(19) Europäisches Patentamt / European Patent Office / Office européen des brevets

(11) **EP 2 243 866 A1**

(12) **EUROPEAN PATENT APPLICATION**
published in accordance with Art. 153(4) EPC

(43) Date of publication:
**27.10.2010 Bulletin 2010/43**

(51) Int Cl.:
**C30B 29/38** *(2006.01)*     **C30B 25/18** *(2006.01)*

(21) Application number: **08870572.8**

(22) Date of filing: **16.12.2008**

(86) International application number:
**PCT/JP2008/072881**

(87) International publication number:
**WO 2009/090821 (23.07.2009 Gazette 2009/30)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **16.01.2008 JP 2008006701**

(71) Applicants:
• **National University Corporation Tokyo University of Agriculture and Technology**
  **Fuchu-shi, Tokyo 183-0057 (JP)**
• **Tokuyama Corporation**
  **Shunan-shi, Yamaguchi-ken 745-8648 (JP)**

(72) Inventors:
• **NAGASHIMA, Toru**
  **Shunan-shi**
  **Yamaguchi 745-8648 (JP)**

• **HAKOMORI, Akira**
  **Shunan-shi**
  **Yamaguchi 745-8648 (JP)**
• **TAKADA, Kazuya**
  **Shunan-shi**
  **Yamaguchi 745-8648 (JP)**
• **ISHIZUKI, Masanari**
  **Shunan-shi**
  **Yamaguchi 745-8648 (JP)**
• **KOUKITU, Akinori**
  **Fuchu-shi**
  **Tokyo 183-0057 (JP)**
• **KUMAGAI, Yoshinao**
  **Fuchu-shi**
  **Tokyo 183-0057 (JP)**

(74) Representative: **Hatt, Anna Louise**
  **Beck Greener**
  **Fulwood House**
  **12 Fulwood Place**
  **London WC1V 6HR (GB)**

(54) **PROCESS FOR PRODUCING LAMINATE COMPRISING AL-BASED GROUP III NITRIDE SINGLE CRYSTAL LAYER, LAMINATE PRODUCED BY THE PROCESS, PROCESS FOR PRODUCING AL-BASED GROUP III NITRIDE SINGLE CRYSTAL SUBSTRATE USING THE LAMINATE, AND ALUMINUM NITRIDE SINGLE CRYSTAL SUBSTRATE**

(57)     The present invention is a method for producing a laminated body, comprising the steps of: (1) preparing a base substrate having a surface formed of a single crystal which is different from the material constituting the Al-based group-III nitride single crystal layer to be formed; (2) forming an Al-based group-III nitride single crystal layer having a thickness of 10 nm to 1.5 $\mu$m on the single crystal surface of the prepared base substrate; (3) forming on the Al-based group-III nitride single crystal layer a non-single crystal layer being 100 times or more thicker than the Al-based group-III nitride single crystal layer without breaking the previously-obtained Al-based group-III nitride single crystal layer; and (4) removing the base substrate. The method provides a substrate which can be suitably used as a base substrate for producing an Al-based group-III nitride single crystal self-supporting substrate, of which surface is formed of a single crystal of an Al-based group-III nitride, and which is free from cracking and warpage.

(Cont. next page)

EP 2 243 866 A1

**Fig. 1**

## Description

Technical Field

The present invention relates to a method for producing a substrate comprising a single crystal of an Al-based group-III nitride such as aluminum nitride.

Background Art

An aluminum nitride (AlN) has a relatively large bandgap, i.e. 6.2 eV, and it is a direct transition type semiconductor, so that aluminum nitride is expected to be used as a material for ultraviolet light emitting device, along with a mixed crystal of gallium nitride (GaN) and indium nitride (InN) as group-III nitrides where AlN belongs to, particularly a mixed crystal having 50 atom % or more Al in the Group-III elements (hereinafter, refer to as "Al-based group-III nitride single crystal".).

To form a semiconductor device such as a ultraviolet light emitting device, it is necessary to form a laminate structure including e.g. clad layer and active layer between an n-type semiconductor layer electrically connected to an n-electrode and a p-type semiconductor layer electrically connected to a p-electrode; in view of luminous efficiency, it is important that all layers have high crystallinity, namely, have less dislocation and less point defects. The laminate structure is formed on a single crystal substrate having a mechanical strength enough to be self-supporting or free-standing (hereinafter, it may be referred to as "self-supporting substrate".). The self-supporting substrate for forming the laminate structure is required to have small difference in lattice constant and small difference in coefficient of thermal expansion with aluminum gallium indium nitride (AlGaInN) which forms the laminate structure; moreover, self-supporting substrate is required to have high thermal conductivity in view of preventing deterioration of the devices. Therefore, to produce a semiconductor device containing aluminum nitride, it is advantageous to form the above layer structure on the Al-based group-III nitride single crystal substrate.

So far, the Al-based group-III nitride single crystal self-supporting substrate has not been commercially available. So, there have been attempts to obtain an Al-based group-III nitride single crystal substrate by method in which a thick film made of Al-based group-III nitride single crystal is formed on a different type of single crystal substrate such as sapphire substrate (hereinafter, a substrate used for forming single crystal thereon may be referred to as "base substrate".) by vapor phase epitaxy method; and then, the formed single crystal substrate is separated from the base substrate. Examples of vapor phase epitaxy method include: hydride vapor phase epitaxy. (HVPE) method, molecular beam epitaxy (MBE) method, and metalorganic vapor phase epitaxy (MOVPE) method. In addition, sublimation-recrystallization method and other epitaxies through liquid phase may also be used. Among them, HVPE method is not suitable for forming crystal lamination structure for semiconductor light emitting device as it is difficult to control the film thickness accurately compared with MOVPE method and MBE method; however, HVPE method can provide a single crystal with good crystallinity at high growth rate, therefore HVPE method is frequently used for vapor phase epitaxy aiming at forming a single crystal thick film.

Nevertheless, when forming a group-III nitride single crystal, such as GaN, including Al-based group-III nitride single crystal by the vapor phase epitaxy method, it is difficult to inhibit dislocation generation from interface by lattice-mismatch between a substrate and a growing group-III nitride. In addition, since the crystal grows at a high temperature around 1000 °C, when a thick film is formed, due to the difference in coefficient of thermal expansion of the film from that of the substrate, warpage occurs after the growth; thereby, dislocation increases by stress and crackings occur, which are problematic. Even when a self-supporting substrate can be obtained without breakage and cracks, inhibiting warpage is extremely difficult; therefore, to obtain an self-supporting substrate, a treatment for making the surface flat by reducing warpage has been necessary.

With respect to the group-III nitride single crystal self-supporting substrate such as GaN substrate, the following method is proposed to solve the above problems. That is, Patent document 1 proposes a method comprising the steps of: growing a group-III nitride single crystal such as GaN on an acid/alkaline-soluble single crystal substrate such as GaAs substrate; growing a polycrystal group-III nitride; removing the single crystal substrate using acid or alkaline solution; and then growing a single crystal group-III nitride layer on the remaining group-III nitride single crystal formed in the first step. In the examples of Patent document 1, in accordance with the method, a 200 nm thick GaAs buffer layer and a 20 nm thick GaN buffer layer were formed on a GaAs (111) substrate where a $SiO_2$ layer is formed on the back side as a protection layer, then, a 2 $\mu$m thick GaN layer with favorable crystallinity and a 100 $\mu$m thick GaN layer wherein less significance is placed on crystallinity (the surface of which is polycrystal) were grown sequentially, the GaAs was dissolved and removed to obtain a GaN substrate, and finally a 15 $\mu$m thick GaN single crystal layer was grown on the surface of the obtained substrate to which the GaAs substrate has abutted; the obtained GaN single crystal layer does not have cracks and does show dislocation number of around $10^5/cm^2$.

Patent Document 1: Japanese Patent No. 3350855

Disclosure of the Invention

Problems to be solved by the Invention

The present inventors initially thought that they could produce a favorable self-supporting substrate by adopting a similar method as proposed in Patent document 1 even when producing an Al-based group-III nitride single crystal self-supporting substrate such as AlN substrate and they actually tried. However, when producing a laminated body having a similar layer construction as that of the examples and removing the base substrate by dissolution, it is difficult to inhibit breakage and cracking; thus, even when an self-supporting substrate having no breakage and cracks can be obtained, warpage cannot be sufficiently inhibited.

Accordingly, an object of the present invention is to provide "a substrate of which surface is formed by an Al-based group-III nitride single crystal and which has no cracks and warpage" to be suitably used as a base substrate for producing an Al-based group-III nitride single crystal self-supporting substrate and a method for efficiently producing a high-quality Al-based group-III nitride single crystal self-supporting substrate.

Means for Solving the Problems

The inventors considered that the reason why the effect observed in the case of GaN when employing the method of Patent document 1 could not be obtained in the case of Al-based group-III nitride was that Al-based group-III nitride contained high ratio of Al, so that it was hard and poor in elasticity and the temperature for vapor phase epitaxy was high, compared with GaN. In a case of forming a thick group-III nitride single crystal film using a base substrate made of e.g. sapphire, SiC, and silicon, due to the difference in lattice constant and difference in coefficient of thermal expansion between the base substrate and the group-III nitride single crystal, stress occurs to the group-III nitride single crystal (hereinafter, it may be referred to as "lattice-mismatch strain".). If a relatively resilient material such as GaN is used, cracking and breakage hardly occur under occurrence of lattice-mismatch strain; however, if a harder material such as Al-based group-III nitride is used, cracking and breakage tend to occur. Moreover, if the temperature of crystal growth is high, for example at 1100 °c, lattice-mismatch strain increases because of shrinkage during cooling step after film forming; thereby the problems becomes more obvious. Hence, the above result was obtained.

Based on the above assumption, the inventors thought that if the Al-based group-III nitride single crystal layer to be formed on the base substrate becomes thinner, cracking and breakage by the lattice-mismatch strain can be inhibited and degree of warpage can be reduced; so, they examined influences of the thickness of the Al-based group-III nitride single crystal layer and the thickness of the Al-based group-III nitride polycrystal layer to be formed on the base substrate as well as the thickness ratio of the both layers on the properties of the substrate (remaining part after removing base substrate). As a result, the inventors discovered that: when the Al-based group-III nitride single crystal layer to be formed on the base substrate is made thicker and is cooled without forming an Al-based group-III nitride polycrystal layer thereon, cracking, breakage, and warpage tends to occur; if an Al-based group-III nitride polycrystal layer is formed on the Al-based group-III nitride single crystal layer and then cooled, even when the single crystal layer is made thicker, cracking, breakage, and warpage are reduced, in other words, the polycrystal layer not only functions to increase thickness but also functions to slightly reduce lattice-mismatch strain. Hence, the inventors completed the present invention.

The first aspect of the present invention is a method for producing a laminated body having a laminate structure comprising: an Al-based group-III nitride single crystal layer having a composition represented by $Al_{1-(x+y+z)}Ga_x In_y B_z N$ (wherein, x, y, and z are independently a rational number of 0 or more and below 0.5; the sum of x, y, and z is below 0.5.); and a non-single crystal layer made of a material for forming the Al-based group-III nitride single crystal layer or a material containing the material for forming the Al-based group-III nitride single crystal layer as a main component, wherein a main surface of the Al-based group-III nitride single crystal layer is exposed, the method comprising the steps of:

(1) preparing a base substrate having a surface formed of a single crystal of which material is different from the material constituting the Al-based group-III nitride single crystal layer to be formed;
(2) forming the Al-based group-III nitride single crystal layer having a thickness of 10 nm to 1.5 $\mu$m on the single crystal surface of the prepared base substrate;
(3) producing a laminated substrate where the Al-based group-III nitride single crystal layer and the non-single crystal layer are formed on the base substrate by forming on the Al-based group-III nitride single crystal layer a non-single crystal layer being 100 times or more thicker than the Al-based group-III nitride single crystal layer without breaking the previously-obtained Al-based group-III nitride single crystal layer; and
(4) removing the base substrate from the laminated substrate obtained in the previous step.

According to the method, it is possible to efficiently produce a laminated body, which is the below-described second aspect of the invention, suitably used as an Al-based group-III nitride single crystal self-supporting substrate.

In the method according to the first aspect of the invention, the non-single crystal layer, in the step (3), is preferably a layer formed of: polycrystal, amorphous, or a mixture thereof of a material for forming the Al-based group-III nitride single crystal layer or of a material containing the material for forming the Al-based group-III nitride single crystal layer as a main component. If the non-single crystal layer is such a layer, stress attributed to the difference in lattice constant of the base substrate with the Al-based group-III nitride single crystal can be slightly reduced. Therefore, by making the Al-based group-III nitride single crystal layer thinner, for example 1.5 μm or less, and making the non-single crystal layer be 100 times or more thicker than the single crystal layer, it becomes possible to carry out cooling after film forming without causing any large warpage and cracking in the Al-based group-III nitride single crystal. The reason for obtaining such an effect is assumed that when the non-single crystal layer is a polycrystal layer, there exists an interface of crystal particles, i.e. grain boundary; thereby, stress (namely, lattice-mismatch strain) caused by difference in lattice constant or coefficient of thermal expansion of Al-based group-III nitride single crystal layer with the base substrate is reduced. When the non-single crystal layer is an amorphous layer, it is assumed that the amorphous layer is made of extremely fine crystals of the Al-based group-III nitride, so that it is a state where no long-period structure of atomic arrangement is formed; thereby, the stress is reduced along the grain boundary of the above extremely fine crystal.

The non-single crystal layer needs to be formed on a previously formed Al-based group-III nitride single crystal layer without breaking the Al-based group-III nitride single crystal layer. The suitable method for forming the non-single crystal layer satisfying these conditions is a method where both formation of the Al-based group-III nitride single crystal layer in the step (2) and formation of the non-single crystal layer in the step (3) are carried out by vapor phase epitaxy method, and the formation of the Al-based group-III nitride single crystal layer and the formation of the non-single crystal layer are successively performed by using a same apparatus. If the method is adopted, adhesiveness between the Al-based group-III nitride single crystal layer and the non-single crystal layer can be higher. It should be noted that it is necessary to meet the above conditions when forming the non-single crystal layer, so that the methods which does not meet the conditions, for example, a method comprising the step of forming a polycrystal body by sintering a ceramic powder cannot be adopted.

The second aspect of the present invention is a laminated body having a laminate structure comprising: an Al-based group-III nitride single crystal layer having a composition represented by $Al_{1-(x+y+z)}Ga_xIn_yB_zN$ (wherein, x, y, and z are independently a rational number of 0 or more and below 0.5; the sum of x, y, and z is below 0.5.) and having a thickness of 10 nm to 1.5 μm; and a non-single crystal layer consisting of a non-sintered material which is made of a material for forming the Al-based group-III nitride single crystal layer or a non-sintered material containing the material for forming the Al-based group-III nitride single crystal layer as a main component and which is 100 times or more thicker than that of the Al-based group-III nitride single crystal layer, a surface of the Al-based group-III nitride single crystal layer being exposed. The laminated body can be suitably used as a substrate for producing an Al-based group-III nitride single crystal self-supporting substrate. Due to the above-mentioned reason, the non-single crystal layer in the laminated body is constituted by a non-sintered material (in the invention, the term "non-sintered material" means a material other than a sintered body made by sintering a powder material.).

The third aspect of the present invention is a method for producing the Al-based group-III nitride single crystal, comprising the step of growing epitaxially an Al-based group-III nitride single crystal (it may be referred to as a "second Al-based group-III nitride single crystal".) having the same composition as or the similar composition to the Al-based group-III nitride constituting the Al-based group-III nitride single crystal layer, on the Al-based group-III nitride single crystal layer of the laminated body according to the second aspect of the invention.

The fourth aspect of the present invention is a method for producing the Al-based group-III nitride single crystal substrate, comprising the step of forming a second Al-based group-III nitride single crystal layer on the Al-based group-III nitride single crystal layer of the laminated body according to the second aspect of the invention by growing epitaxially an Al-based group-III nitride single crystal (i.e. the second Al-based group-III nitride single crystal) having the same composition as or the similar composition to the Al-based group-III nitride constituting the Al-based group-III nitride single crystal layer.

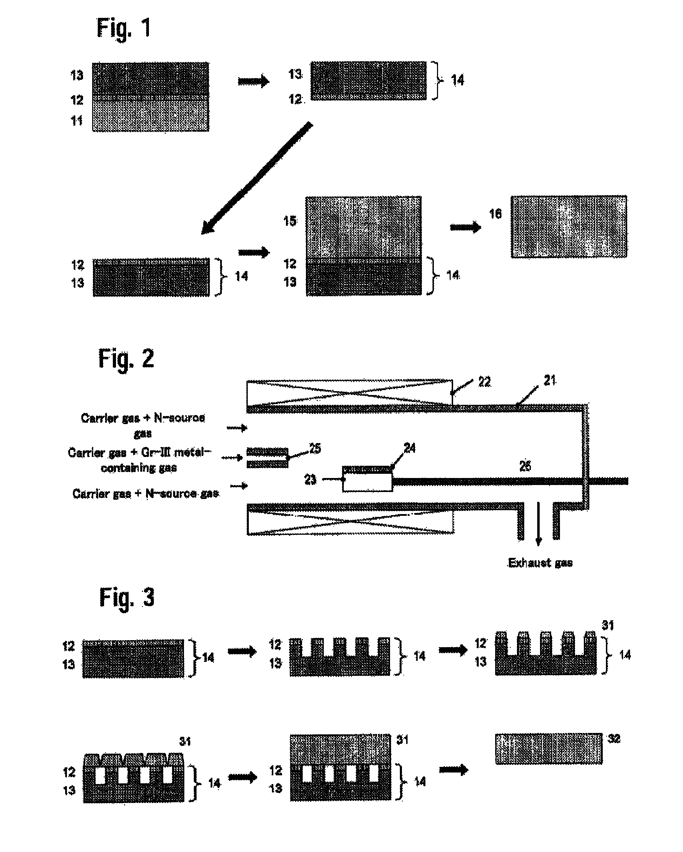

As described above, the first to fourth aspects of the invention are related to each other; in the fourth aspect of the invention, the laminated body according to the second aspect of the invention which is produced by the first aspect of the invention is used as a base substrate, then, by employing the method for producing the Al-based group-III nitride single crystal according to the third aspect, an Al-based group-III nitride single crystal substrate is produced. The relations are schematically shown in Fig. 1.

As shown in Fig. 1, the first method of the invention comprises: the steps of (1) to (3) for forming a laminated substrate where an Al-based group-III nitride single crystal layer 12 and a non-single crystal layer 13 are laminated, in the order mentioned, on a base substrate; and the step (4) for separating the base substrate 11 from the laminated substrate, to produce the laminated body 14 according to the second aspect of the invention where the Al-based group-III nitride single crystal layer 12 and non-single crystal layer 13 are adhered. Later, in the third aspect of the invention, the laminated body 14 is used as a base substrate of which the exposed surface of Al-based group-III nitride single crystal layer 12 is the crystal growing surface, to grow epitaxially the second Al-based group-III nitride single crystal. Finally, in the fourth aspect of the invention, a second Al-based group-III nitride single crystal layer 15 is obtained by growing the second Al-based group-III nitride single crystal in a layer form, and then at least a part of the Al-based group-III nitride single crystal layer 15 is separated to obtain an Al-based group-III nitride single crystal substrate 16 usable for an self-supporting substrate.

The present inventors produced the AlN single crystal substrates usable as an self-supporting substrate in the above manner and evaluated the substrates. Then, the inventors discovered that when growing the AlN single crystal in a temperature range of 1400-1900 °C, concentration of impurity such as oxygen and silicon contained in the obtained AlN single crystal substrate becomes extremely low, thereby extremely high purity can be attained, which has never been attained by the AlN single crystal substrate produced by the conventional methods.

That is, the invention also provides, as the fifth aspect of the invention, an aluminum nitride single crystal substrate having an oxygen concentration of $2.5 \times 10^{17}$ atom/cm$^3$ or less and a ratio (A/B) of a spectral intensity (A) at an emission wavelength of 210 nm to a spectral intensity (B) at an emission wavelength of 360 nm under photoluminescence measurement at 23 °C being 0.50 or more.

In general, when forming the AlN single crystal layer on a base substrate by the vapor phase epitaxy method, it is inevitable that atoms contained in the material constituting the base substrate are taken in the AlN single crystal layer as an impurity by thermal diffusion. Moreover, when employing an apparatus using materials being the source of oxygen or silicon, such as quartz, as a vapor phase epitaxy apparatus, these elements contaminate the crystal as impurities from the atmosphere during the growth of the crystal. As a result, the AlN single crystal substrate obtained by growing the AlN single crystal on a sapphire substrate or a silicon substrate by HVEPE method using quartz-made apparatus usually contains oxygen of about $10^{18-19}$ atom/cm$^3$ and silicon of about $10^{18}$ atom/cm$^3$. Further, even when producing the AlN single crystal substrate by sublimation method, the lower limit of the oxygen concentration is about $3 \times 10^{17}$ atom/cm$^3$ (see Journal of Crystal Growth (2008), doi: 10.1016/j.jcrysgro. 2008. 06032).

On the other hand, with respect to the aluminum nitride single crystal substrate according to the fifth aspect of the invention, the laminated body according to the second aspect of the invention is used as the base substrate and the invention succeeds in inhibiting contamination by impurities such as oxygen and silicon by performing vapor phase epitaxy of the AlN single crystal within a particular temperature range. Below is the inventors' assumption regarding the reasons why these effects can be obtained. That is, the concentration of the impurities seems to significantly decline, because: (i) the concentration of atoms as the impurities contained in the base substrate to be used is originally low, (ii) the crystal growing surface of the base substrate is an "N-polar plane of the AlN single crystal" where AlN does not grow by the conventional vapor phase epitaxy method, so that polarity reversion is caused at the initial phase of AlN growth on the N-polar plane and a kind of barrier layer is formed, whereby diffusion of the atoms as impurities from the base substrate is inhibited; and (iii) contamination by impurities from the atmosphere is inhibited by growing crystal in a high temperature range of 1400-1900 °C.

Effects of the Invention

According to the first aspect of the invention, the laminated body according to the second aspect of the invention can be efficiently produced. In addition, by the method, by controlling the shape and size of the base substrate to be used, it is possible to easily change the shape and size of the obtained laminated body.

The laminated body according to the second aspect of the invention is constituted so that only the top layer is made of Al-based group-III nitride single crystal and the Al-based group-III nitride single crystal exhibits excellent quality having no macroscopic defect such as cracking. Moreover, the main surface formed of the Al-based group-III nitride single crystal does not warp but does show excellent smoothness. Therefore, the laminated body of the invention can be suitably used as a base substrate for the Al-based group-III nitride single crystal to grow. Conventional base substrate is composed of a single crystal, such as silicon single crystal and sapphire, having a different lattice constant with the Al-based group-III nitride single crystal to be formed; so, when growing the Al-based group-III nitride single crystal using the conventional base substrate, it is inevitable to avoid various problems attributed to the lattice constant difference. However, when using the laminated body of the present invention as the base substrate, the Al-based group-III nitride single crystal grows on the surface of the homogeneous Al-based group-III nitride single crystal; thereby the above problems are not caused.

According to the third aspect of the invention relating to the method for producing the Al-based group-III nitride single crystal substrate, by using the laminated body of the second aspect of the invention as the base substrate, it is possible to grow a high-quality Al-based group-III nitride single crystal which is free from warpage and cracking and which has little microscopic defects such as dislocation. The laminated body in which the layer made of such a high-quality Al-based group-III nitride single crystal (second Al-based group-III nitride single crystal layer) is formed can be used as it is as an self-supporting substrate for forming the laminate structure to be a semiconductor device such as LED; while, by separating the second Al-based group-III nitride single crystal layer, the self-supporting substrate may be formed. As above, shape and size of the laminated body of the second aspect of the invention can be adequately determined depending on the base substrate to be used for production of the laminated body; as a result, enlargement and selection of shape of the high-quality Al-based group-III nitride single crystal become easier.

The aluminum nitride single crystal substrate according to the fifth aspect of the invention is the one which attains significant reduction in concentration of oxygen atom and silicon atom as impurities and which exhibits excellent optical characteristics, so that it can be effectively used as a substrate for ultraviolet light emitting device.

Brief Description of the Drawings

Fig. 1 is a schematic view showing the outline of the present invention and the production method;
Fig. 2 is a schematic view showing an HVPE apparatus used in the Examples; and
Fig. 3 is a schematic view showing the production method of the invention employing Epitaxial lateral overgrowth (ELO) method.

Description of the Reference Numerals

11    base substrate
12    Al-based group-III nitride single crystal layer
13    non-single crystal layer
14    laminated body of the invention
15    second Al-based group-III nitride single crystal layer
16    substrate formed of the second Al-based group-III nitride single crystal
21    fused silica-made reaction tube
22    external heating device
23    susceptor
24    base substrate
25    nozzle (for introducing group-III metal-containing gas)
26    electrode for electrification of the susceptor
31    second Al-based group-III nitride single crystal layer
32    substrate formed of the second Al-based group-III nitride single crystal

Best Mode for Carrying Out the Invention

In the production method according to the first embodiment of the invention, by carrying out the following steps (1) to (4), a laminated body, which has a laminate structure comprising: an Al-based group-III nitride single crystal layer having a composition represented by $Al_{1-(x+y+z)}Ga_xIn_yB_zN$ (wherein, x, y, and z are independently a rational number of 0 or more and below 0.5; the sum of x, y, and z is below 0.5.); and a non-single crystal layer made of a material for forming the Al-based group-III nitride single crystal layer or a material containing the material for forming the Al-based group-III nitride single crystal layer as a main component, wherein a main surface of the Al-based group-III nitride single crystal layer is exposed, is produced.

The steps (1) to (4) are:

(1) preparing a base substrate having a surface formed of a single crystal of which material is different from the material constituting the Al-based group-III nitride single crystal layer to be formed;
(2) forming the Al-based group-III nitride single crystal layer having a thickness of 10 nm to 1.5 $\mu$m on the single crystal surface of the prepared base substrate;
(3) producing a laminated substrate where the Al-based group-III nitride single crystal layer and the non-single crystal layer are formed on the base substrate by forming on the Al-based group-III nitride single crystal layer a non-single crystal layer being 100 times or more thicker than the Al-based group-III nitride single crystal layer without breaking the previously-obtained Al-based group-III nitride single crystal layer; and
(4) removing the base substrate from the laminated substrate obtained in the previous step.

The object of the production method of the invention, i.e. the laminated body (it may also be the laminated body of the second aspect of the invention.) has a laminate structure comprising: an Al-based group-III nitride single crystal layer which has a composition represented by $Al_{1-(x+y+z)}Ga_xIn_yB_zN$ (wherein, x, y, and z are independently a rational number of 0 or more and below 0.5; the sum of x, y, and z is below 0.5.) and which has a thickness of 10 nm to 1.5 $\mu$m; and a non-single crystal layer consisting of a non-sintered material which is made of a material for forming the Al-based group-III nitride single crystal layer or a non-sintered material containing the material for forming the Al-based group-III nitride single crystal layer as a main component and which is 100 times or more thicker than that of the Al-based group-III nitride single crystal layer, wherein a main surface of the Al-based group-III nitride single crystal layer is exposed.

< Al-based group-III nitride single crystal layer >

The compound constituting the Al-based group-III nitride single crystal layer has a composition represented by $Al_{1-(x+y+z)}Ga_xInyB_zN$. In the composition, x, y, and z are independently a rational number of 0 or more and below 0.5, preferably below 0.3, and most preferably below 0.2; the sum of x, y, and z is below 0.5, preferably below 0.3, and most preferably below 0.2. It should be noted that the Al-based group-III nitride single crystal layer may contain elements of impurity such as transitional metal elements, Ti, Ni, Cr, Fe, and Cu, within the range which does not give crucial adverse influence to its crystalline characteristics (it is usually 5000 ppm or less, preferably 1000 ppm or less.).

The thickness of the Al-based group-III nitride single crystal layer needs to be 10 nm to 1.5 $\mu$m. If the thickness of the Al-based group-III nitride single crystal layer is out of the range, it is difficult to obtain the laminated body which is free from cracking and breakage and which has little warpage. Due to the reasons for production, the thickness of the Al-based group-III nitride single crystal layer is more preferably 50 nm to 1.0 $\mu$m.

< Non-single crystal layer >

The non-single crystal layer may be a layer which is made of a material for forming the Al-based group-III nitride single crystal layer or a material containing the material for forming the Al-based group-III nitride single crystal layer as a main component and which is formed of a non-single crystal material; in view of ease of production and reduction of stress, it is preferably an Al-based group-III nitride having the same composition as or the similar composition to the material constituting the Al-based group-III nitride single crystal slayer. Here, the term "similar composition to" means that, when comparing compositions of two materials, absolute values of $\Delta\{1-(x+y+z)\}$, $\Delta x$, $\Delta y$, and $\Delta z$, as a composition difference of each group-III element, are 0.1 or less, preferably 0.05 or less. The term "composition difference" means the difference between composition ratio of the group-III elements of the material constituting the Al-based group-III nitride single crystal layer and composition ratio of the group-IIT elements of the group-III nitride constituting the non-single crystal layer. For example, in a case where the composition of the material constituting the Al-based group-III nitride single crystal layer is $Al_{0.7}Ga_{0.2}In_{0.1}N$, while the composition of the group-III nitride constituting the non-single crystal layer is $Al_{0.7}Ga_{0.25}In_{0.05}N$, $\Delta\{1-(x+y+z)\} = 0.7-0.7 = 0$, $\Delta x = 0.2-0.25 = -0.05$, $\Delta y = 0.1-0.05 = 0.05$, and $\Delta z = 0-0 = 0$.

The crystal structure of the non-single crystal is preferably polycrystal, amorphous, or a mixture thereof. When the non-single crystal layer is a layer formed of the above crystal structure, it is possible to reduce stress attributed to the difference in lattice constant between the base substrate and the Al-based group-III nitride single crystal.

The thickness of the non-single crystal layer needs to be a thickness which inhibits by the formation of the non-single crystal layer a large warpage and cracking in the Al-based group-III nitride single crystal layer even under the change of ambient temperature and where the separated laminated body can maintain a self-supportable strength even after separating the base substrate in the step (4) . So, the non-single crystal layer is 100 times or more thicker than that of the Al-based group-III nitride single crystal layer, preferably 300 times or more thicker, more preferably a thickness of 100-3000 $\mu$m, while satisfying the above conditions.

With respect to the laminated body, the Al-based group-III nitride single crystal layer and the non-single crystal layer are not necessarily adhered directly. These may be adhered through a thin oxide layer. Moreover, about the laminated body as a production object, although it is not particularly necessary, other layer may be formed on the non-single crystal layer to improve reinforcing effect and workability of separation in the step (4).

< Step (1) >

To produce the above laminated body, the present invention firstly has the step of preparing a base substrate having a surface formed of a single crystal made of a material which is different from the material constituting the Al-based group-III nitride single crystal layer to be formed (Step (1)). As the base substrate to be used, a substrate which is made of a single crystal material that is conventionally known to be able to use as a base substrate can be used without any limitation. However, when using a material such as gallium arsenide which tends to be decomposed or sublimed at a temperature of vapor phase epitaxy of the Al-based group-III nitride single crystal, the constituent elements may be taken in the Al-based group-III nitride single crystal as impurities and the material may change the composition of the Al-based group-III nitride single crystal; therefore, a single crystal substrate of a material which is stable at the above temperature is preferably used. Examples of the substrate include: sapphire substrate, silicon nitride single crystal substrate, zinc oxide single crystal substrate, silicon single crystal substrate, and zirconium boride single crystal substrate. Among them, in view of easy separation when separating the base substrate in the step (4), a silicon single crystal substrate is preferably used. Silicon can be chemically etched using a solution, so that the base substrate can be easily removed in the step (4) . It should be noted that the size and shape of the base substrate are practically restricted by the production apparatus; however, in theory, these can be freely determined.

< Step (2) >

In the step (2) of the method of the invention, an Al-based group-III nitride single crystal layer is formed on the single crystal surface of the prepared base substrate. As methods for forming the Al-based group-III nitride single crystal layer, though various methods such as vapor phase epitaxy method and liquid phase method can be adopted as conventional methods capable of forming the Al-based group-III nitride single crystal layer, in view of easy formation and easy film-thickness control of the single crystal layer, vapor phase epitaxy method is preferably adopted. When adopting the vapor phase epitaxy method, there is a merit that the following formation of the non-single crystal layer can be performed by only minor change of e.g. temperature and material supply condition. Examples of the vapor phase epitaxy method include: not only HVPE method, MOVPE method, and MBE method, but also known vapor phase epitaxy methods such as sputtering method, Pulse Laser Deposition (PLD) method, and sublimation-recrystallization method.

The production condition for forming the group-III nitride single crystal layer by these methods is not different from that of the conventional method except for setting the thickness of the film to be grown within the above range. The Al-based group-III nitride single crystal layer may also be formed by a stepwise procedure.

Whether or not a film formed on the base substrate is a single crystal is determined by measurements in the θ-2θ mode of the X-ray diffraction measurement. The term "measurements in the θ-2θ mode" means a method for measuring diffraction by fixing a detector at the position of an angle of 2θ for the incidence angle θ to the sample. In general, X-ray diffraction profile is measured by setting 2θ within the range of 10-100°; in the case of Al-based group-III nitride, if only the (002) diffraction and the (004) diffraction are observed, the obtained Al-based group-III nitride can be identified as a single crystal. For example, in the case of AlN, if the (002) diffraction is observed around 2θ = 36.039° and the (004) diffraction is observed around 2θ = 76.439°, it can be identified as a single crystal; in the same manner as AlN, in the case of aluminum gallium nitride (AlGaN), if only the (002) diffraction and the (004) diffraction are observed, it can be identified as a single crystal. The diffraction angle 2θ varies depending on the composition of Al and Ga; in the case of GaN, the (002) diffraction is observed around 2θ = 34.56°, the (004) diffraction is observed around 2θ = 72.91°, so that the (002) diffraction is observed within the range of 2θ = 34.56-36.039° and the (004) diffraction is observed within the range of 2θ = 72.91-76.439°. It should be noted that the Al-based group-III nitride single crystal layer usually contains about $10^{18\text{-}19}$ atom/cm$^3$ of oxygen and about $10^{18}$ atom/cm$^3$ of silicon.

< Step (3) >

In the step (3) of the method of the invention, the non-single crystal layer is formed on the Al-based group-III nitride single crystal layer thus obtained to produce a laminated substrate where the Al-based group-III nitride single crystal layer and the non-single crystal layer are laminated, in the order mentioned, on the base substrate.

The non-single crystal layer may be a layer which is made of a material constituting the Al-based group-III nitride single crystal layer or a material containing the material constituting the Al-based group-III nitride single crystal layer as a main component and which is formed of a non-single crystal material. In view of ease of production and reduction of stress, a layer formed of the polycrystal, amorphous, or a mixture thereof of the Al-based group-III nitride having the same composition as or the similar composition to the material constituting the Al-based group-III nitride single crystal layer is preferably used. By forming the non-single crystal layer, even during the growth and cooling, warpage and cracking of the Al-based group-III nitride single crystal layer and the non-single crystal layer can be inhibited. This is presumed that when the non-single crystal layer is a polycrystal layer, interface between crystal particles, namely, grain boundary exists, so that the stress caused by the lattice constant difference and difference in the coefficient of thermal expansion between the single crystal layer and the base substrate (lattice-mismatch strain) is reduced. It is also presumed that when the non-single crystal layer is an amorphous layer, it seems a state where the crystal forming the amorphous layer itself is extremely fine and long-period structure of atomic arrangement is not formed, so that the lattice-mismatch strain is reduced along the grain boundary of the extremely fine crystal.

When the non-single crystal layer is a polycrystal formed by the vapor phase epitaxy method, the non-single crystal layer tends to show crystalline orientation in the (002)-direction of the Al-based group-III nitride crystal. Here, the term "crystalline orientation" means that the individual crystal axises of the polycrystal which forms the non-single crystal layer oriented into a particular direction. The crystalline orientation can be measured qualitatively by X-ray diffraction measurements in θ-2θ mode. More specifically, the X-ray diffraction measurement is carried out from the direction where the polycrystal layer is exposed; when an intensity ratio ($I_{002}/I_{100}$) of the diffraction intensity of a (002) plane (i.e. $I_{002}$) to the diffraction intensity of a (100) plane (i.e. $I_{100}$) is above 1, 1.5 or more for sure, the non-single crystal layer has a crystalline orientation in the (002)-direction of the Al-based group-III nitride crystal. In general, it is known that a powder and a polycrystal body obtained by sintering the powder do not show such crystalline orientation; the intensity ratio shown in, for example, X-ray diffraction data base (JCPDS: 25-1133) is below 1.

In the step (3), formation of the non-single crystal layer needs to be carried out without destroying the Al-based group-III nitride single crystal layer to be the base. The destruction in this context is not limited to the state associated with complete separation such as breakage, the concept may include a state where a part of continuity is significantly damaged, such as cracking.

When the thickness of the Al-based group-III nitride single crystal layer is as thin as 1 $\mu$m, there is little risk that the Al-based group-III nitride single crystal layer is destroyed by cooling; with increase of the thickness over 1 $\mu$m, the risk of destruction becomes higher particularly in the cooling process. Hence, to form a non-single crystal layer without destroying the Al-based group-III nitride single crystal layer, preferably, the cooling step is not be carried out after formation of the Al-based group-III nitride crystal layer or the non-single crystal layer is formed under cooling within the temperature range of with fluctuation range of 500 °C or less. Due to the reasons above, preferably, the formation of the Al-based group-III nitride single crystal layer in the step (2) and the formation of the non-single crystal layer in the step (3) are both carried out by vapor phase epitaxy method, and the formation of the Al-based group-III nitride single crystal layer and the formation of the non-single crystal layer are successively performed by using the same apparatus. Here, the term "successively" means that "the substrate is not cooled down to the room temperature and is not taken out from the apparatus". When forming the non-single crystal layer having a sufficient thickness under these conditions, even though the Al-based group-III nitride single crystal layer is formed thicker, the non-single crystal layer which can reduce the lattice-mismatch strain is formed while keeping a heating state where lattice-mismatch strain is small; so, by the stress reduction effect of the non-single crystal layer, lattice-mismatch strain when cooling the substrate becomes small (compared with the case where the non-single crystal layer is not formed), thereby destruction and warpage can be inhibited. Consequently, it is possible to form an Al-based group-III nitride single crystal layer having a thickness exceeding 1 $\mu$m, whereas such a layer formed by the conventional vapor phase epitaxy method has problems of warpage and destruction.

If the above conditions are met, the non-single crystal layer may be formed by changing film-forming conditions immediately after the formation of the Al-based group-III nitride single crystal layer; or the non-single crystal layer may be formed certain time-period after the formation of the Al-based group-III nitride single crystal layer. A plurality of non-single crystal layers can be formed by changing film-forming conditions such as temperature, pressure, duration, raw material gas supply, and carrier gas flow. Alternatively, the non-single crystal layer may be formed after forming a thin oxide film on the surface of previously formed Al-based group-III nitride single crystal layer by supplying an oxygen-containing raw material gas. When the oxide film exists on the surface of the Al-based group-III nitride single crystal layer, crystalline orientation to the non-single crystal layer to be formed thereon is inhibited. This phenomenon is explained as a result of decrease in intensity ratio ($I_{002}/I_{100}$) of the X-ray diffraction measurement. Increase of occurrence of mis-fit due to the intentional intervention of oxide by oxidizing the surface of the Al-based group-III nitride single crystal layer or deterioration of surface flatness at the time of oxidation are assumed as the factor which disturbs orientation of the non-single crystal layer. In any case, presumably, the oxide film functions as a discontinuous surface of crystalline orientation, thus a larger number of grain boundaries are introduced in the non-single crystal layer; thereby stress reduction effect of the non-single crystal layer can be attained.

< Step (4) >

The method of the invention comprises the steps of: producing a laminated substrate by laminating the Al-based group-III nitride single crystal layer and the non-single crystal layer, in the order mentioned, on the base substrate in this way; and then, as the step (4), removing the base substrate from the obtained laminated substrate.

As a method for removing the base substrate, if the material of the base substrate has a certain chemical durability (for example, sapphire, silicon nitride, zinc oxide, and zirconium boride), cutting along the interface between the base substrate and the single crystal layer is suitably employed. When the laminated body obtained after cutting is used as a base substrate for producing a self-supporting substrate for forming a laminate structure to be a semiconductor device such as LEDs, due to the rough cut surface, there is a risk of deteriorating the quality of crystal to be grown; thus, the cut surface is preferably ground. In this case, when cutting is carried out so that the base substrate remains in the surface to leave the Al-based group-III nitride single crystal layer in the surface, and then the remaining part of the base substrate is removed by grinding, it is possible to obtain a laminated body having a smooth Al-based group-III nitride single crystal layer.

On the other hand, when the material of the base substrate is silicon, the base substrate can be easily removed by chemical etching. For chemical etching, for instance, a mixed acid of hydrofluoric acid, nitric acid and acetic acid is suitably used; by immersing the laminated body in the mixed acid and left undisturbed, the silicon as the base substrate can be removed. The Al-based group-III nitride single crystal layer in the laminated body thus obtained after removing the base substrate has a surface as smooth as that of a silicon substrate. Because of this, when using a silicon substrate as the base substrate, the step of grinding the surface of the Al-based group-III nitride single crystal layer can be omitted, which is advantageous. For the same reason, when the material of the base substrate is zinc oxide, since zinc oxide is soluble in both acid solution and alkaline solution, it can be used as a base substrate.

After adequately applying secondary processing such as thickness adjustment, shape adjustment, surface treatment, and backside treatment, as required, the laminated body of the invention obtained by separating the base substrate is used in various applications.

< Method for producing the Al-based group-III nitride single crystal >

The thus obtained laminated body of the invention can be suitably used as a base substrate for the Al-based group-III nitride single crystal to grow, or a substrate formed of Al-based group-III nitride single crystal, particularly a base substrate for producing a self-supporting substrate.

When producing the Al-based group-III nitride single crystal, there is a known technology as follows, comprising the steps of: making difference in height in the surface of the substrate by forming a large number of minute recesses or minute protrusions being arranged at random or regularly in the surface of the base substrate; starting the growth of crystal from relatively higher portions of the surface of the substrate; and growing the single crystal not only in the vertical direction but also in the horizontal direction, to reduce crystal defects during the growth of the single crystal in the horizontal direction. The technology is called Epitaxial Lateral Overgrowth (ELO); by employing the technology, it is possible to obtain a high-quality group-III nitride single crystal of which crystal defects are reduced.

Even in the case of using the laminated body of the invention as the base substrate, to employ the ELO method, it is possible to provide a plurality of recesses or protrusions on one main surface of the Al-based group-III nitride single crystal layer being exposed. The embodiment employing the ELO method on the method of the invention is schematically shown in Fig. 3. As shown in Fig. 3, when forming the second Al-based group-III nitride single crystal layer 31 onto the base substrate obtained by forming grooves on the surface of the laminated body 14 of the second aspect of the invention, crystal grows not only in the vertical direction but also in the horizontal direction; so, the grown crystals on the surface of the protrusions of the groove eventually coalesce with each other to form a single layer. Therefore, as shown in Fig. 3, even when the non-single crystal layer is exposed at the bottom of the grooves, the effect of ELO method can be obtained; thereby, by separating the second Al-based group-III nitride single crystal layer 31, a substrate formed of the second Al-based group-III nitride single crystal 32 can be obtained. The shape and size of recesses or protrusions to be formed as well as distribution (or alignment style) of the recesses or protrusions are substantially the same as those of the conventional ELO method; however, in general, difference in height between the top surface of the recesses and protrusions is within the range of 100-50000 nm, and the width of recesses and protrusions is within the range of 0.1-20 $\mu$m.

To produce the Al-based group-III nitride single crystal using the laminated body of the invention as a base substrate, an Al-based group-III nitride single crystal having the same composition as or the similar composition to that of the compound constituting the Al-based group-III nitride single crystal layer may be grown epitaxially on the Al-based group-III nitride single crystal layer of the laminated body of the invention. To produce an Al-based group-III nitride single crystal substrate using the laminated body of the invention as a base substrate, the second group-III nitride single crystal layer is firstly formed by growing epitaxially the Al-based group-III nitride single crystal having the same composition as or the similar composition to that of the compound constituting the Al-based group-III nitride single crystal layer of the laminated body of the invention in accordance with the above method, then, as required, at least a part of the second group-III nitride single crystal layer is separated, for example, by cutting method.

Here, the "similar composition to that of the compound" means the conditions that: (1) the range of difference in composition ratio between the material constituting the Al-based group-III nitride single crystal layer and the material constituting the non-single crystal layer may be wider than that described in the method for producing the laminated body of the invention; and (2) the absolute value of the composition difference regarding each group-III element between the Al-based group-III nitride single crystal for constituting the Al-based group-III nitride single crystal layer of the laminated body of the invention and the second Al-based group-III nitride single crystal is 0.3 or less.

When using the laminated body of the invention as the base substrate, since the crystal growing surface is made of a group-III nitride single crystal having the same composition as or the similar composition to the second Al-based group-III nitride single crystal to be grown, no lattice-mismatch strain is caused or little lattice-mismatch strain is caused. Therefore, even when the crystal grows into an extremely thick layer having a thickness well over 10 $\mu$m, for example, 200 $\mu$m or more, preferably 1000 $\mu$m or more, warpage, cracking, and breakage hardly occur during the crystal growth or cooling of the substrate after the crystal growth; consequently, it is possible to form a second Al-based group-III nitride single crystal having a sufficient thickness as a self-supporting substrate made of a high-quality single crystal.

As the method for growing epitaxially the second Al-based group-III nitride single crystal, a conventional vapor phase epitaxy method such as HVPE method, MOVPE method, MBE method, sputtering method, PLD method, and sublimation-recrystallization method can be employed. Other than these, various known methods such as solution-growth technique, e.g. flux method, can be employed. Since film-thickness can be easily controlled and a high-quality crystal can also be obtained, vapor phase epitaxy method is preferably employed; among them, in view of high growth rate, HVPE method is particularly preferably employed.

< Aluminum nitride single crystal substrate >

When using the laminated body of the invention as the base substrate, the crystal growing surface is the face which abuts to the "base substrate having a surface formed of a single crystal made of a material different from that constituting the Al-based group-III nitride single crystal layer" such as a silicon base substrate in the production process of the laminated body of the invention; the crystal growing surface is the surface which is not exposed in the conventional vapor phase epitaxy.

In the case of AlN single crystal having a hexagonal wurtzite-type crystal structure, as it does not have a symmetric face with respect to the c-axis direction, this cause front-and-back relation; whereby it is known that one face becomes a N-polar plane(nitrogen polar plane) and the other one becomes an Al-polar plane (aluminum polar plane), and the vapor phase epitaxial growth occurs so that the N-polar plane is as the lower exposure face and the Al-polar plane is as the upper exposure plane.

It should be noted that the nitrogen polarity in the aluminum nitride single crystal, as described in Japanese Patent Application Laid-open No. 2006-253462, is to show the direction of atomic arrangement. When focusing on an aluminum atom, a crystal in which a nitrogen atom is vertically arranged on the upper side from an aluminum atom is called aluminum polarity; while, a crystal in which an aluminum atom is vertically arranged on the upper side from an nitrogen atom is called nitrogen polarity. These polarities can usually be determined by etching treatment using potassium hydroxide aqueous solution. The determination is described in, for example, Applied Physics Letter, Vol. 72 (1998) 2480, MRS Internet Journal Nitride Semiconductor Research, Vol. 7, No. 4, 1-6 (2002), and Japanese Patent Application Laid-open No. 2006-253462. In other words, in the film of the aluminum nitride single crystal, the plane having nitrogen polarity is dissolved by etching using a potassium hydroxide aqueous solution; on the other hand, the opposite plane having aluminum polarity is not dissolved by etching treatment using the potassium hydroxide aqueous solution. Therefore, for example, when immersing one face for 5 minutes in a 50 mass % concentration of potassium hydroxide aqueous solution heated at 50 °C and then observing it with an electron microscope, if the shape of the plane is not changed at all compared with the plane before immersing in the potassium hydroxide aqueous solution, the plane is the Al-polar plane; and the back-side plane of which shape is changed is the N-polar plane.

Since the vapor phase epitaxy of the AlN single crystal shows the above characteristics, if the Al-based group-III nitride single crystal layer of the laminated body of the invention is made of AlN, the crystal growing surface becomes N-polar plane; so, when AlN is grown thereon by vapor phase epitaxy, polarity reversion is caused. It is assumed that a kind of barrier layer to prevent diffusion of element of impurity from the base substrate is formed by the polarity reversion; the AlN obtained by vapor phase epitaxy shows a high degree of purity. In addition to this, when using the laminated body of the invention as the base substrate and an AlN single crystal is grown as the second Al-based group-III nitride single crystal on the crystal growing surface of the base substrate by vapor phase epitaxy, by setting the temperature of the base substrate at a time of crystal growth in the range of 1400 °C to 1900 °C, preferably 1400 °C to 1700 °C, and more preferably 1450 °C to 1600 °C, it is possible to attain purity farther higher. As a result, the fifth aspect of the invention, i.e. "an aluminum nitride single crystal substrate having an oxygen concentration of $2.5 \times 10^{17}$ atom/cm$^3$ or less and a ratio (A/B) of a spectral intensity (A) at an emission wavelength of 210 nm to a spectral intensity (B) at an emission wavelength of 360 nm under photoluminescence measurement at 23 °C is 0.50 or more" can be obtained. Here, the ratio (A/B) of the spectral intensity is an index which reflects a state in which impurity oxygen and crystal defects form complex; if the oxygen concentration is low and the crystal is in a good state having little defects, the value of the ratio (A/B) becomes larger.

In the aluminum nitride single crystal substrate of the invention, the oxygen concentration is constant in the depth direction. Further, in the aluminum nitride single crystal substrate, the oxygen concentration may be set at $2.2 \times 10^{17}$ atom/cm$^3$ or less, and the ratio of the spectral intensity (A/B) may be set at 0.80 or more. Thus, the aluminum nitride single crystal substrate of the invention exhibits extremely high purity and excellent optical characteristics, so it can be suitably used for applications such as ultraviolet light emitting device. The oxygen concentration is preferably as low as possible and the ratio (A/B) is preferably as high as possible; in view of industrial production, the lower limit of the oxygen concentration is $1.0 \times 10^{16}$ atom/cm$^3$ and the upper limit of the ratio (A/B) is 20.00. In other words, the preferable oxygen concentration is $1.0 \times 10^{16}$ atom/cm$^3$ to $2.2 \times 10^{17}$ atom/cm$^3$ and the preferable ratio (A/B) is 0.8 to 20.00. Further, the aluminum nitride single crystal substrate of the invention contains silicon at a concentration of, preferably, $5.5 \times 10^{17}$ atom/cm$^3$ or less, more preferably $1.0 \times 10^{16}$ atom/cm$^3$ to $5.0 \times 10^{17}$ atom/cm$^3$.

It should be noted that the oxygen concentration, silicon concentration, and the ratio (A/B) in the aluminum nitride single crystal substrate of the invention are determined in accordance with the following method.

(1) Method for measuring the oxygen concentration and silicon concentration

The oxygen concentration and silicon concentration were measured in accordance with the secondary ion mass spectrometry (SIMS) having a feature of detecting elements existing in the vicinity of the surface at a high sensitivity. The measuring apparatus used was "IMS-4f" manufactured by CAMECA Instruments, Inc.. The measurement was carried out by irradiating a primary ion beam of cesium ion at an accelerating voltage of 14.5 kV to a region having a diameter of 30 $\mu$m with an incident angle of 60° (from the normal direction of the test sample), and the average of the strength profile of the obtained $O^+$ and $Si^+$ secondary ions in the depth direction was determined as the oxygen concentration and the silicon concentration.

(2) Method for calculating the ratio of spectral intensity obtained by photoluminescence measurement at 23 °C

The measuring apparatus used was "HR800 UV" (laser source: ExciStar S-200) manufactured by HORIBA, Ltd.. Irradiation to the test sample was carried out by using ArF laser having a wavelength of 193 nm as the excitation light source to excite the test sample. The ArF laser was irradiated in the direction perpendicular to the test sample. After imaging the luminescence emitted from the test sample by focusing lens, the spectrum was detected by spectrometer, then the spectral intensity with respect to the wavelength was obtained. The measurement was carried out at room temperature, at an irradiation duration of 10 seconds, a cumulated number of 3 times, a hole diameter of 1000 $\mu$m, and the grating of 300 grooves/mm. The temperature during the measurement was 23 °C.
The inventors focused on the spectral intensity (A) at a wavelength of 210 nm equivalent to that of the band-edge luminescence of aluminum nitride and the spectral intensity (B) at a wavelength of 360 nm derived from oxygen as an impurity and standardized the ratio based on the following formula to calculate the ratio of spectral intensity.

```
Formula:

[Spectral intensity ratio (A/B)] =

[Spectral intensity (A) at 210 nm]/[Spectral intensity (B) at

360 nm]
```

Hereinafter, the invention will be more specifically described by way of the following examples. However, the invention is not limited by these Examples.

(Example 1)

By employing HVPE method as the vapor phase epitaxy method, a substrate for producing a self-supporting substrate was produced. In this Example, a (111) silicon single crystal substrate having a diameter of 2 inches and a thickness of 280 $\mu$m was used as the base substrate; the material of the single crystal layer and the non-single crystal layer was aluminum nitride.
The HVPE apparatus shown in Fig. 2 comprises: a reactor main body comprising a cylindrical fused silica reaction tube 21; an external heating means 22 arranged outside the fused silica reaction tube 21; and a susceptor 23 arranged inside the fused silica reaction tube 21. From one end of the reaction tube 21, a carrier gas and a raw material gas are supplied; while, from an opening provided in the side wall at the vicinity of the other end of the reaction tube, the carrier gas and unreacted gas are discharged. It should be noted that the external heating means 22 is not used for heating the substrate 24 but is mainly used for the purpose of keeping the temperature of the reaction gas in the reaction region at a predetermined temperature, which is not essential. As the external heating means 22, resistance heating apparatus, radio-frequency heating apparatus, high-frequency induction heating apparatus, and lamp heater may be used; in the Example, a resistance heating apparatus was used. The susceptor 23 can support the substrate 24 thereon.
At the raw material gas supply side of the reaction tube in the apparatus shown in Fig. 2, aluminum trichloride gas as a Group-III metal-containing gas diluted with the carrier gas is supplied from a nozzle 25, and ammonia gas as a nitrogen-source gas diluted with the carrier gas is supplied through the space between the nozzle 25 and the inner wall of the reaction tube as a passage. The passage of the aluminum trichloride gas is connected to the "source of the group-III metal-containing gas" (not shown) through a pipe. The "source of the group-III metal-containing gas" means a source to supply, to the nozzle 25, aluminum trichloride gas produced by reaction of hydrogen chloride gas and a metal aluminum by providing metal aluminum in the fused silica reaction tube, heating it in an resistance heating-type electric furnace at 500 °C placed outside the reaction tube, and supplying thereto hydrogen chloride gas together with carrier gases such as hydrogen and nitrogen.

On the other hand, the passage for nitrogen-source gas is connected to the "source of nitrogen-source gas" (not shown) by a pipe through a flow regulator, and the pipe located at the downstream side from the flow regulator is connected to a pipe which connects to the source of carrier gas through the flow regulator, so as to dilute the nitrogen-source gas with the carrier gas at a desired dilution ratio.

In the HVPE apparatus shown in Fig. 2, a complex-heater where the carbon heating element is coated by boron nitride is used as the susceptor 23. The base substrate 24 is placed on the susceptor 23 and heated. The end face of the heater has an electrode portion, so the electric power is supplied from outside to the susceptor through the electrode. Since pyrolytic boron nitride which coats the heating element is favorable in corrosion resistance against hydrogen gas, aluminum trichloride gas as a group-III metal-containing gas, and ammonia gas as a nitrogen-source gas, the susceptor can be stably used in the temperature range from room temperature to 1700 °C.

After placing the base substrate on the susceptor in the reactor within the apparatus, a mixed carrier gas of hydrogen and nitrogen was introduced in the reactor. The pressure within the system at this phase was set at 400 Torr. Then, the temperature of the reaction tube was raised up to 500 °C using the external heating means. Meanwhile, the susceptor was heated by supplying electric power to the susceptor and the temperature of the base substrate was kept at 1100 °C for 1 minute . After that, into the reactor, the aluminum trichloride gas was introduced from the nozzle 25 and the ammonia gas was introduced from the passage between the nozzle 25 and the inner wall of the reaction tube and the state was kept for 5 minutes; finally, 0.5 $\mu$m thick aluminum nitride single crystal layer was grown on the base substrate.

Thereafter, supply of aluminum trichloride gas was once stopped, and layer-forming conditions were changed to form a polycrystal layer as the non-single crystal layer on the single crystal layer. Specifically, the pressure was changed to 500 Torr and the temperature of the reaction tube was maintained at 500 °C by the external heating means. By reducing the supply of electric power to the susceptor, the temperature of the base substrate was decreased to 1000 °C. These operations were performed within 5 minutes after suspension of aluminum trichloride supply. Thereafter, aluminum trichloride gas was supplied again and the state was kept for 120 minutes, to grow aluminum nitride polycrystal to 250 $\mu$m thick.

After the 120 minutes holding, electric power supply to the susceptor was gradually decreased and eventually stopped over 4 hours; then, the temperature of the external heating means was further decreased down to the room temperature over 3 hours. After cooling, a laminated body comprising: a base substrate, a single crystal layer, and a polycrystal layer was taken out from the reaction tube.

Thereafter, the above laminated body was immersed for 12 hours in a 200 mL chemical etching solution obtained by mixing hydrofluoric acid (concentration of 49%), nitric acid (concentration of 70%), acetic acid (concentration of 99%), and an ultrapure water at a ratio of 1:2:1:2, to dissolve and remove silicon as the base substrate. Later, the chemical etching solution was removed by rinsing using the ultrapure water; thus, a substrate for producing the self-supporting substrate was obtained.

When measuring the diffraction intensity of the (002) plane (i.e. $I_{002}$) and the diffraction intensity of the (100) plane (i.e. $I_{100}$) by X-ray diffraction measurement of the substrate for producing the self-supporting substrate in the θ-2θ mode from the side where the polycrystal layer was exposed, the intensity ratio ($I_{002}/I_{100}$) was 3.8. The surface of the side where the single crystal layer was exposed was the same mirror surface as that of the silicon substrate used as the base substrate. In addition, by 3D shape measurement using a blue-violet laser microscope, apparent warpage of the substrate for producing the self-supporting substrate was evaluated. More specifically, the warpage was evaluated by obtaining the height profile about the side of the substrate for producing the self-supporting substrate where the single crystal was exposed by using a laser microscope at 50-fold magnification and calculating radius of curvature of the substrate for producing the self-supporting substrate under spherical approximation. When the single crystal surface of the substrate for producing the self-supporting substrate convexes downwardly, the radius of curvature was defined as "positive"; when it convexes upwardly, the radius of curvature was defined as "negative". Regardless of positive or negative, larger radium of curvature means smaller warpage. As a result, the radius of curvature of the substrate for producing the self-supporting substrate in the Example of the present invention was -1.8 m, which was of substantially no problem.

Further, by employing the HVPE method, the second group-III nitride single crystal layer was formed on the side of single crystal of the substrate for producing the self-supporting substrate of the Example. The substrate for producing the self-supporting substrate was placed on the susceptor in the reactor of the apparatus so that the side of single crystal faces upwardly, then a mixed carrier gas of hydrogen and nitrogen was introduced in the reactor. The pressure within the system at this phase was set at 200 Torr. Later, the temperature of the reaction tube was raised up to 500 °C using the external heating means. Meanwhile, the susceptor was heated by supplying electric power to the susceptor and the temperature of the base substrate was kept at 1500 °C. After that, the aluminum trichloride gas and the ammonia gas were introduced into the reactor and then the state was held for 6 hours to grow 300 $\mu$m thick aluminum

nitride single crystal layer on the substrate for producing the self-supporting substrate. Then, the substrate was cooled down to the room temperature and taken out from the reactor.

Later, the laminated body was cut along the vicinity of interface between the substrate for producing the self-supporting substrate and the aluminum nitride single crystal layer as the second group-III nitride single crystal layer, then a 260 $\mu$m thick aluminum nitride single crystal layer was taken as an aluminum nitride single crystal self-supporting substrate. When observing the obtained aluminum nitride single crystal self-supporting substrate by light microscope, no cracking was observed over the entire surface of the 2-inch diameter substrate. Moreover, the oxygen concentration of the aluminum nitride single crystal self-supporting substrate was $2.1 \times 10^{17}$ atom/cm$^3$, the silicon concentration of the same was $5.2 \times 10^{17}$ atom/cm$^3$, and the ratio (A/B) of a spectral intensity (A) at an emission wavelength of 210 nm to a spectral intensity (B) at an emission wavelength of 360 nm under photoluminescence measurement at 23 °C was 0.98.

(Example 2)

In Example 2, the apparatus and substrate described in the Example 1 were used. In addition to the procedures of Example 1, Example 2 further comprises the step of: supplying for 10 seconds 0.1 sccm oxygen gas as an oxygen containing gas after forming a single crystal layer on the base substrate and stopping the supply of aluminum trichloride gas as the raw material gas. Growing conditions of the single crystal layer and the polycrystal layer as well as stripping condition of the silicon substrate were the same as those of Example 1; in this way, a substrate for producing the self-supporting substrate having the same thickness as that of Example 1 was obtained.

When measuring the diffraction intensity of the (002) plane (i.e. $I_{002}$) and the diffraction intensity of the (100) plane (i.e. $I_{100}$) by X-ray diffraction measurement of the substrate for producing the self-supporting substrate in the θ-2θ mode from the side where the polycrystal layer was exposed, the intensity ratio ($I_{002}/_{100}$) was 1.5. The surface of the side where the single crystal layer was exposed was a mirror surface as smooth as that of the silicon substrate used for the base substrate; no cracking was observed. When the warpage of the substrate for producing the self-supporting substrate was measured in the same method as that of Example 1, the radius of curvature was -3.2 m; the warpage was reduced by providing an oxidation layer.

Further, by employing the HVPE method, a 350 $\mu$m thick aluminum nitride single crystal layer was grown on the side of single crystal of the substrate for producing the self-supporting substrate of the Example in the same manner as Example 1. The substrate was cooled down to the room temperature and taken out from the reactor. The laminated body was cut along the vicinity of interface between the substrate for producing the self-supporting substrate and the aluminum nitride single crystal layer, then 300 $\mu$m thick aluminum nitride single crystal layer was taken as an aluminum nitride single crystal self-supporting substrate. When observing the obtained aluminum nitride single crystal self-supporting substrate by light microscope, no cracking was observed over the entire surface of the 2-inch diameter substrate. Moreover, the oxygen concentration of the aluminum nitride single crystal self-supporting substrate was $2.0 \times 10^{17}$ atom/cm$^3$, the silicon concentration of the same was $5.0 \times 10^{17}$ atom/cm$^3$, and the ratio (A/B) of a spectral intensity

(A) at an emission wavelength of 210 nm to a spectral intensity
(B) at an emission wavelength of 360 nm under photoluminescence measurement at 23 °C was 1.12.

(Example 3)

In Example 3, the same apparatus and substrate as those of Example 1 were used and an amorphous layer was formed as the non-single crystal layer of Example 1. On the silicon substrate as the base substrate, the first layer was grown for 2 minutes under the same raw material supply conditions as those of Example 1, to form a 0.2 $\mu$m thick single crystal layer. Then, supply of aluminum trichloride was suspended and the pressure was changed to 500 Torr. While keeping the temperature of reaction tube by the external heating means at 500 °C, the temperature of the base substrate was set at 800 °C by reducing the electric power supply to the susceptor. These operations were carried out in 10 minutes after suspension of the supply of aluminum trichloride gas. Next, the supply of aluminum trichloride gas was resumed and it was held for 240 minutes to grow the aluminum nitride amorphous layer further 220 $\mu$m. The silicon substrate was removed by chemical etching, thus a substrate for producing the self-supporting substrate was obtained.

When measuring the diffraction intensity of the (002) plane (i.e. $I_{002}$) and the diffraction intensity of the (100) plane (i.e. $I_{100}$) by X-ray diffraction measurement of the substrate for producing the self-supporting substrate in the θ-2θ mode from the side where the non-crystal layer is exposed, peak was not observed; thereby it was identified as an amorphous layer. The surface of the side where the single crystal layer was exposed was a mirror surface as smooth as that of silicon substrate and no cracking was observed. When measuring the warpage of the substrate for producing the self-supporting substrate in the same manner as Example 1, radius of curvature was -2.3 m; by setting the thickness of the first single crystal layer smaller and providing an amorphous layer as the non-single crystal layer, the warpage was further reduced.

Further, by employing the HVPE method, a 380 $\mu$m thick aluminum nitride single crystal layer was grown on the side of single crystal of the substrate for producing the self-supporting substrate of the Example in the same manner as Example 1. The substrate was cooled down to the room temperature and taken out from the reactor. By grinding and removing the amorphous layer from the amorphous side of the substrate for producing the self-supporting substrate, 360 $\mu$m thick aluminum nitride single crystal layer was taken as an aluminum nitride single crystal self-supporting substrate. When observing the obtained aluminum nitride single crystal self-supporting substrate by light microscope, no cracking was observed over the entire surface of the 2-inch diameter substrate.

(Example 4)

In Example 4, single crystal side of the substrate for producing the self-supporting substrate obtained by the method of Example 1 was processed to have asperity pattern and the ELO method was applied thereto. On the single crystal side of the substrate for producing the self-supporting substrate, 3 $\mu$m wide photoresist patterns were formed at 3 $\mu$m interval by lithography; then, etching of the substrate for producing the self-supporting substrate was carried out to a depth of 5 $\mu$m from the opening of the photoresist by inductively-coupled plasma etching device. After etching, the photoresist was rinsed with organic solvent and removed. The resultant substrate was placed in the reactor of the HVPE device, and then an aluminum nitride was formed thereon as the second group-III nitride single crystal layer. A mixed carrier gas of hydrogen and nitrogen was introduced into the reactor and the pressure within the system was set at 200 Torr. While the temperature of reaction tube was raised up to 500 °C using the external heating means, the susceptor was heated by supplying electric power to the susceptor, to keep the temperature of the base substrate at 1400 °C. Next, aluminum trichloride gas and ammonia gas were introduced and the state was held for 1 hour to grow 10 $\mu$m thick aluminum nitride single crystal layer on the substrate for producing the self-supporting substrate. Later, the substrate was cooled down to the room temperature and taken out from the reactor. The surface of the aluminum nitride single crystal layer was a mirror surface and no cracking was observed on the surface by using light microscope. Moreover, when observing the cross section of the laminated body comprising the substrate for producing the self-supporting substrate and the aluminum nitride single crystal layer by using scanning electron microscope, it was observed that growth of aluminum nitride single crystal layer starts from the protrusions of the substrate for producing the self-supporting substrate and the recess portions formed in the substrate for producing the self-supporting substrate was covered over by the grown aluminum nitride single crystal layer. So, it was proved that even if the ELO method was employed, the substrate of Example 4 could be used as the substrate for producing the self-supporting substrate.

(Comparative example 1)

In Comparative example 1, while employing the HVPE method in the same manner as Example 1 and using silicon substrate as the substrate; instead of the non-single crystal layer of Example 1, the single crystal layer grown on the base substrate was made furthermore thicker.
The single crystal layer made of AlN was grown on the silicon substrate for 5 minutes under the same conditions as those of Example 1. Thereafter, supply of aluminum trichloride gas was suspended; then, while keeping the temperature of reaction tube at 500 °C by the external heating means, the electric power supply to the susceptor was increased to raise the temperature of the base substrate up to 1300 °C. These operations were carried out in 5 minutes after suspension of the supply of aluminum trichloride gas. Next, aluminum trichloride gas and ammonia gas were introduced and the state was held for 360 minutes to continuously grow the aluminum nitride single crystal layer. After the growth, although the film-thickness of the AlN single crystal was estimated to be 151 $\mu$m based on the change of weight of the substrate, cracking occurred in the AlN single crystal layer. Still further, in the same manner as Example 1, production of the substrate for producing the self-supporting substrate was attempted by removing the silicon substrate employing chemical etching, due to the cracking which have occurred in the AlN single crystal layer, the substrate for producing the self-supporting substrate could not maintain its original dimention.

(Comparative example 2)

Comparative example 2 is the one where condition of film-thickness was same as that of Example of Patent document 1 (Japanese patent No. 3350855). A silicon substrate was used; and growing conditions of the single crystal layer and the polycrystal layer were adjusted to make only the growing time the same as that of Patent document 1. Specifically, AlN single crystal layer was grown to 2 $\mu$m and then the polycrystal layer was grown to 100 $\mu$m. As a result, cracking occurred not only in the single crystal layer but also in the polycrystal layer, thereby the original dimension of the substrate could not be maintained. When evaluating the warpage with the broken pieces employing the above method, the radius of curvature was -0.1 m; it was found out that the degree of warpage was not practically acceptable.

Industrial Applicability

The laminated body of the present invention can be suitably used as a base substrate for producing the Al-based group-III nitride single crystal self-supporting substrate. The aluminum nitride single crystal substrate of the invention exhibits excellent optical characteristics, so that it is useful for a substrate for ultraviolet light emitting device.

**Claims**

1. A method for producing a laminated body having a laminate structure comprising: an Al-based group-III nitride single crystal layer having a composition represented by $Al_{1-(x+y+z)}Ga_xIn_yB_zN$ (wherein, x, y, and z are independently a rational number of 0 or more and below 0.5; the sum of x, y, and z is below 0.5.); and a non-single crystal layer made of a same material for forming the Al-based group-III nitride single crystal layer or a material containing the material for forming the Al-based group-III nitride single crystal layer as a main component, wherein one main surface of the Al-based group-III nitride single crystal layer is exposed, the method comprising the steps of:

   (1) preparing a base substrate having a surface formed of a single crystal of which material is different from the material constituting the Al-based group-III nitride single crystal layer to be formed;
   (2) forming the Al-based group-III nitride single crystal layer having a thickness of 10 nm to 1.5 $\mu$m on the single crystal surface of the prepared base substrate;
   (3) producing a laminated substrate where the Al-based group-III nitride single crystal layer and the non-single crystal layer are formed on the base substrate by forming on the Al-based group-III nitride single crystal layer a non-single crystal layer being 100 times or more thicker than the Al-based group-III nitride single crystal layer without breaking the previously-obtained Al-based group-III nitride single crystal layer; and
   (4) removing the base substrate from the laminated substrate obtained in the previous step.

2. The method according to claim 1 further comprising, before the step (3), the step of oxidizing at least a part of the surface of the Al-based group-III nitride single crystal layer formed in the step (2).

3. The method according to claim 1 or 2, wherein the non-single crystal layer, in the step (3), is formed of: polycrystal, amorphous, or a mixture thereof of a material for forming the Al-based group-III nitride single crystal layer or of a material containing the material for forming the Al-based group-III nitride single crystal layer as a main component.

4. The method according to any one of claims 1 to 3, wherein formation of the Al-based group-III nitride single crystal layer in the step (2) and formation of the non-single crystal layer in the step (3) are both carried out by vapor phase epitaxy method, and the formation of the Al-based group-III nitride single crystal layer and the formation of the non-single crystal layer are successively performed by using a same apparatus.

5. The method according to any one of claims 1 to 4, wherein a silicon single crystal substrate is used as the base substrate in the step (1).

6. A laminated body having a laminate structure comprising:

   an Al-based group-III nitride single crystal layer having a composition represented by $Al_{1-(x+y+z)}Ga_xIn_yB_zN$ (wherein, x, y, and z are independently a rational number of 0 or more and below 0.5; the sum of x, y, and z is below 0.5.) and having a thickness of 10 nm to 1.5 $\mu$m; and
   a non-single crystal layer consisting of a non-sintered material which is made of a same material for forming the Al-based group-III nitride single crystal layer or a non-sintered material containing the material for forming the Al-based group-III nitride single crystal layer as a main component and which is 100 times or more thicker than the Al-based group-III nitride single crystal layer,
   one surface of the Al-based group-III nitride single crystal layer being exposed.

7. The laminated body according to claim 6, wherein the non-single crystal layer consisting of a non-sintered material consists of polycrystal, amorphous, or a mixture thereof.

8. The laminated body according to claim 6 or 7, wherein the non-single crystal layer consisting of a non-sintered material consists of polycrystal and an intensity ratio ($I_{002}/I_{100}$) of diffraction intensity of a (002) plane (i.e. $I_{002}$) to diffraction intensity of a (100) plane (i.e. $I_{100}$) is 1 or more when carrying out X-ray diffraction measurement of the polycrystal layer from the direction opposite to the exposed Al-based group-III nitride single crystal layer.

9.   The laminated body according to any one of claims 6 to 8, wherein the main surface of the exposed Al-based group-III nitride single crystal layer is provided with a plurality of recesses and protrusions.

10.  A method for producing the Al-based group-III nitride single crystal, comprising the step of growing epitaxially an Al-based group-III nitride single crystal having the same composition as or the similar composition to the Al-based group-III nitride constituting the Al-based group-III nitride single crystal layer, on the Al-based group-III nitride single crystal layer of the laminated body according to any one of claims 6 to 9.

11.  A method for producing the Al-based group-III nitride single crystal substrate, comprising the step of forming a second Al-based group-III nitride single crystal layer on the Al-based group-III nitride single crystal layer of the laminated body according to any one of claims 6 to 9 by growing epitaxially an Al-based group-III nitride single crystal having the same composition as or the similar composition to the Al-based group-III nitride constituting the Al-based group-III nitride single crystal layer.

12.  The method according to claim 11, further comprising the step of separating at least a part of the second Al-based group-II nitride single crystal layer.

13.  An aluminum nitride single crystal substrate having an oxygen concentration of $2.5 \times 10^{17}$ atom/cm$^3$ or less and a ratio (A/B) of a spectral intensity (A) at an emission wavelength of 210 nm to a spectral intensity (B) at an emission wavelength of 360 nm under photoluminescence measurement at 23 °C being 0.50 or more.

14.  The aluminum nitride single crystal substrate according to claim 13, wherein the silicon concentration is $5.5 \times 10^{17}$ atom/cm$^3$ or less.


**Amended claims under Art. 19.1 PCT**

1.   A method for producing a laminated body having a laminate structure comprising: an Al-based group-III nitride single crystal layer having a composition represented by $Al_{1-(x+y+z)}Ga_xIn_yB_zN$ (wherein, x, y, and z are independently a rational number of 0 or more and below 0.5; the sum of x, y, and z is below 0.5.) ; and a non-single crystal layer made of a same material for forming the Al-based group-III nitride single crystal layer or a material containing the material for forming the Al-based group-III nitride single crystal layer as a main component, wherein one main surface of the Al-based group-III nitride single crystal layer is exposed, the method comprising the steps of:

(1) preparing a base substrate having a surface formed of a single crystal of which material is different from the material constituting the Al-based group-III nitride single crystal layer to be formed;
(2) forming the Al-besed group-III nitride single crystal layer having a thickness of 10 nm to 1.5 μm on the single crystal surface of the prepared base substrate;
(3) producing a laminated substrate where the Al-based group-III nitride single crystal layer and the non-single crystal layer are formed on the base substrate by forming on the Al-based group-III nitride single crystal layer a non-single crystal layer being 100 times or more thicker than the Al-based group-III nitride single crystal layer without breaking the previously-obtained Al-based group-III nitride single crystal layer; and
(4) removing the base substrate from the laminated substrate obtained in the previous step.

2.   The method according to claims 1 further comprising, before the step (3), the step of oxidizing at least a part of the surface of the Al-based group-III nitride single crystal layer formed in the step (2).

3.   The method according to claim 1 or 2, wherein the non-single crystal layer, in the step (3), is formed of: polycrystal, amorphous, or a mixture thereof of a material for forming the Al-based group-III nitride single crystal layer or of a material containing the material for forming the Al-based group-III nitride single crystal layer as a main component.

4.   The method according to any one: or claims 1 to 3, wherein formation of the Al-base-d group-III nitride single crystal layer in the step (2) and formation of the non-single crystal layer in the step (3) are both carried out by vapor phase epitaxy method, and the formation of the Al-based group-III nitride single crystal layer and the formation or the non-single crystal layer are successively performed bey using a same apparatus.

**5.** The method according to any one of claims 1 to 4, wherein a silicon single crystal substrate is used as the base substrate in the step (1).

**6.** A laminated body having a laminate structure comprising:

an Al-based group-III nitride single crystal layer having a composition represented by $Al_{1-(x+y+z)}Ga_xIn_yB_zN$ (wherein, x, y, and z are independently a rational number of 0 or more and below 0.5; the sum of x, y, and z is below 0.5.) and having a thickness of 10 nm to 1.5 $\mu$m; and
a non-single crystal layer consisting of a non-sintered material which is made of a same material for forming the Al-based group-III nitride single crystal layer or a non-sintered material containing the maternal four forming the Al-based group-III nitride single crystal layer as a main component and which is 100 times or more thicket than the Al-based group-III nitride single crystal layer,
one surface of the Al-based group-III nitride single crystal layer being exposed.

**7.** The laminated body according to claim 6, wherein the non-single crystal layer consisting of a non-sintered material consists of polycrystal, amorphous, or a mixture thereof.

**8.** The laminated body according to claim 6 or 7, wherein the non-single crystal layer consisting of a non-sintered material consists of polycrystal and an intensity ratio ($I_{002}/I_{100}$) of diffraction intensity of a (002) plane (i.e. $I_{002}$) to diffraction intensity of a (100) plane (i.e. $I_{100}$) is I or more when carrying out X-ray diffraction measurement of the polycrystal layer from the direction opposite to the exposed Al-based group-III nitride single crystal layer.

**9.** The laminated body according to any one of claims 6 to 8, wherein the main surface of the exposed Al-based group-III nitride single crystal layer is provided with a plurality of recesses and protrusions.

**10.** A method for producing the Al-based group-III nitride singe crystal, comprising the step of growing epitaxially an Al-based group-III nitride single crystal having the same composition, as or the similar composition to the Al-based group-III nitride constituting the Al-based group-III nitride single crystal layer, on the Al-based group-III nitride single crystal layer of the laminated body according to any one of claims 6 to 9.

**11.** A method, for producing the Al-based group-III nitride single crystal substrate, comprising the step of forming a second Al-based group-III nitride single crystal layer on the Al-based group-III nitride single crystal layer of the laminated body according to any one of claims 6 to 9 by growing epitaxially an Al-based group-III nitride single crystal having the same composition as or the similar composition to the Al-based group-III nitride constituting the Al-based group-III nitride single crystal layer.

**12.** The method according to claim 11, further comprising the step of separating at least a part of the second Al-based group-III nitride single crystal layer.

**13.** (Cancelled)

**14.** (Cancelled)

## Fig. 1

## Fig. 2

Carrier gas + N-source gas

Carrier gas + Gr-III metal-containing gas

Carrier gas + N-source gas

Exhaust gas

## Fig. 3

## INTERNATIONAL SEARCH REPORT

| International application No. |
|---|
| PCT/JP2008/072881 |

A. CLASSIFICATION OF SUBJECT MATTER
*C30B29/38*(2006.01)i, *C30B25/18*(2006.01)i

According to International Patent Classification (IPC) or to both national classification and IPC

B. FIELDS SEARCHED

Minimum documentation searched (classification system followed by classification symbols)
C30B29/38, C30B25/18

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2005-343704 A (Sumitomo Electric Industries, Ltd.),<br>15 December, 2005 (15.12.05),<br>Par. Nos. [0040] to [0046]<br>(Family: none) | 13,14<br>1-12 |
| A | JP 2006-103998 A (Sumitomo Electric Industries, Ltd.),<br>20 April, 2006 (20.04.06),<br>Full text<br>(Family: none) | 1-14 |
| A | JP 9-115832 A (Nippon Telegraph And Telephone Corp.),<br>02 May, 1997 (02.05.97),<br>Full text<br>(Family: none) | 1-14 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>03 March, 2009 (03.03.09) | Date of mailing of the international search report<br>10 March, 2009 (10.03.09) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/072881

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2007-042854 A  (Tokyo University of Agriculture and Technology), 15 February, 2007 (15.02.07), Full text (Family: none) | 1-14 |
| A | Y. KUMAGAI et al., Preparation of a freestanding AlN substrate by hydride vapor phase epitaxy at 1230°C using (111)Si as a starting substrate, Japanese Journal of Applied Physics, 2007, Vol.46, No.17, pp.L389-L391 | 1-14 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3350855 B

- JP 2006253462 A

**Non-patent literature cited in the description**

- *Journal of Crystal Growth,* 2008
- *Applied Physics Letter,* 1998, vol. 72, 2480

- *MRS Internet Journal Nitride Semiconductor Research,* 2002, vol. 7 (4), 1-6